(19) Europäisches Patentamt
European Patent Office
Office européen des brevets

(11) **EP 2 177 000 B1**

(12) **EUROPÄISCHE PATENTSCHRIFT**

(45) Veröffentlichungstag und Bekanntmachung des Hinweises auf die Patenterteilung:
**16.04.2014 Patentblatt 2014/16**

(21) Anmeldenummer: **08786125.8**

(22) Anmeldetag: **14.07.2008**

(51) Int Cl.:
**H04L 25/02** *(2006.01)*    **H03K 19/0185** *(2006.01)*

(86) Internationale Anmeldenummer:
**PCT/EP2008/059168**

(87) Internationale Veröffentlichungsnummer:
**WO 2009/007464 (15.01.2009 Gazette 2009/03)**

(54) **Schaltungsanordnung und Verfahren zum Treiben mindestens einer differentiellen Leitung**

Circuit arrangement and method for driving at least one differential line

Circuit et procédé d'excitation d'au moins un conducteur différentiel

(84) Benannte Vertragsstaaten:
**AT BE BG CH CY CZ DE DK EE ES FI FR GB GR HR HU IE IS IT LI LT LU LV MC MT NL NO PL PT RO SE SI SK TR**

(30) Priorität: **12.07.2007 DE 102007032876**

(43) Veröffentlichungstag der Anmeldung:
**21.04.2010 Patentblatt 2010/16**

(73) Patentinhaber: **Silicon Line GmbH
80687 Muenchen (DE)**

(72) Erfinder:
• **GROEPL, Martin
87527 Sonthofen/Oberallgaeu (DE)**
• **HOELTKE, Holger
80995 München (DE)**

(74) Vertreter: **Hofmann, Andreas et al
Richter Werdermann Gerbaulet Hofmann
Patentanwälte
Postfach 33 02 11
80062 München (DE)**

(56) Entgegenhaltungen:
**US-A- 5 012 384     US-A1- 2003 094 977
US-B1- 6 812 733**

## Beschreibung

### Technisches Gebiet

Die vorliegende Erfindung betrifft das technische Gebiet des Treibens von Leitungen mit bestimmter Leitungsimpedanz zum Zwecke der, insbesondere digitalen, Datenübertragung von mindestens einer Datenquelle, zum Beispiel von mindestens einer ersten integrierten Schaltung, zu mindestens einer Datensenke, zum Beispiel zu mindestens einer zweiten integrierten Schaltung.

Im Spezielleren betrifft die vorliegende Erfindung eine Schaltungsanordnung, insbesondere Treiberrausgangsstufe, gemäß dem Oberbegriff des Anspruchs 1 sowie ein Verfahren zum Treiben mindestens einer differentiellen Leitung gemäß dem Oberbegriff des Anspruchs 6 *(vgl. Druckschrift US 2003/094977 A1 aus dem Stand der Technik).*

Im Rahmen der vorliegenden Erfindung wird unter dem Begriff "verschwindend" weniger als etwa ein Prozent der Ausgangsimpedanz verstanden, die die Schaltungsanordnung, insbesondere Treiberausgangsstufe, ausgangsseitig aufweist; unter dem Begriff "nicht verschwindend" werden mehr als etwa zehn Prozent der Ausgangsimpedanz verstanden, die die Schaltungsanordnung, insbesondere Treiberausgangsstufe, ausgangsseitig aufweist.

### Stand der Technik

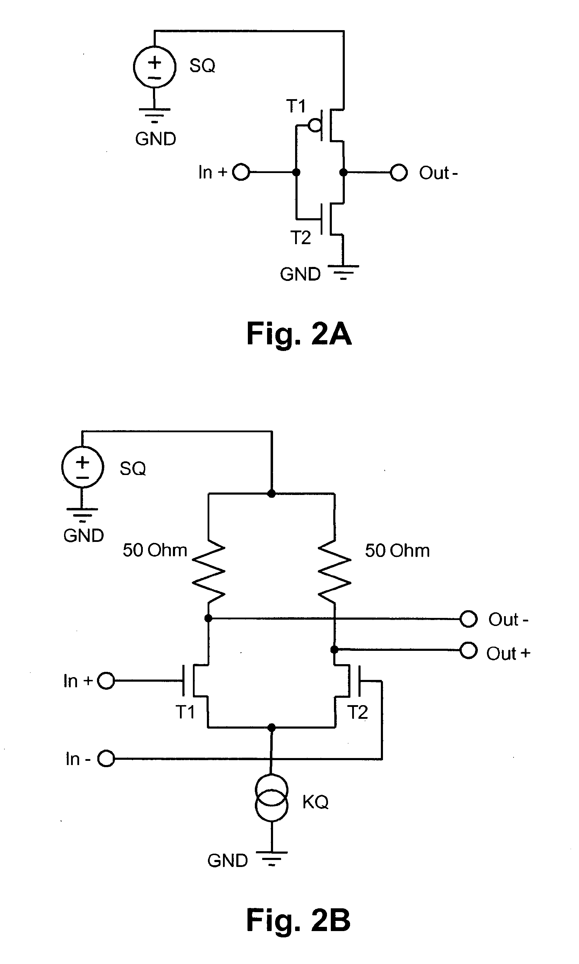

Bei der Übertragung niedriger Datenraten ist eine Impedanzanpassung zwischen dem Treiber und der Leitung im Regelfall unüblich bzw. häufig nicht erforderlich. Hierbei werden oft nur einfache Inverterschaltungen eingesetzt; vgl. anhand Fig. 2A exemplarisch veranschaulichte erste Schaltungsanordnung gemäß dem Stand der Technik:

Die bekannte Schaltungsanordnung gemäß Fig. 2A weist einen Ausgangsknoten auf (= single-ended); beim (in Fig. 2A oberen, das heißt) der Spannungsquelle SQ zugeordneten Transistor handelt es sich um einen p-Kanal-Transistor, beim (in Fig. 2A unteren, das heißt) dem Referenzpotential (= zum Beispiel Erdpotential oder Nullpotential oder Masse) zugeordneten Transistor handelt es sich um einen n-Kanal-Transistor.

Um hohe Datenraten fehlerarm übertragen zu können, wird typischerweise eine Anpassung der Impedanz der Ausgangsstufe oder Ausgangsimpedanz $Z_{Out}$ eines Leitungstreibers an die Leitungs(eingangs)impedanz $Z_L$ vorgenommen (Anpassung: $Z_{Out} = Z_L =$ zum Beispiel fünfzig Ohm). Durch eine derartige Impedanzanpassung werden Signalreflexionen absorbiert, die ansonsten die Qualität des Sendesignals beeinträchtigen würden.

Des Weiteren werden hohe Datenraten zum Zwecke der Störungsminimierung häufig als differentielle Signale übertragen; Beispiele hierfür sind LVDS (= Low Voltage Differential Swing), SLVS (= Scalable Low Voltage Swing), differentielles ECL (= Emitter Coupled Logic), differentielles LVPECL (= Low Voltage Positive Emitter Coupled Logic) oder dergleichen.

Bei derartigen differentiellen Schaltungsrealisierungen liegt nicht mehr nur ein Ausgangsknoten (= sogenante single-ended Anordnung), sondern eine differentielle Ausgangsstufe vor.

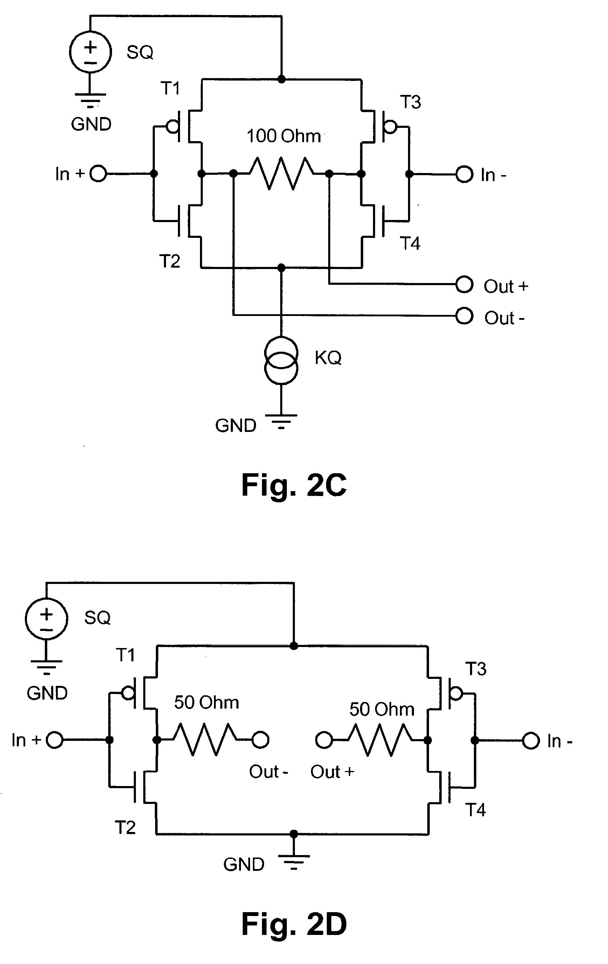

Dies bedeutet, dass Störungen gegen das Referenzpotential, zum Beispiel gegen das Erdpotential oder gegen das Nullpotential oder gegen Masse, nicht mehr zum Tragen kommen, denn derartige Störungen heben sich durch die Bildung einer Differenz bei den beiden Ausgangssignalen gegenseitig auf; vgl. anhand Fig. 2B, Fig. 2C, Fig. 2D exemplarisch veranschaulichte differentielle Schaltungsanordnungen gemäß dem Stand der Technik:

In Fig. 2B liefert die (idealisiert eine verschwindende Impedanz aufweisende) Spannungsquelle SQ etwa 1,2 Volt; die beiden Lastwiderstände von jeweils exemplarisch fünfzig Ohm (jeweils gegen das Referenzpotential, zum Beispiel gegen das Erdpotential oder gegen das Nullpotential oder gegen Masse) dienen als Ausgangsimpedanz, so dass zwischen Out + und Out - insgesamt etwa einhundert Ohm liegen; das Eingangssignal an In - weist gegenüber dem Eingangssignal an In + eine Phasenverschiebung von 180 Grad auf.

Wenn am ersten n-Kanal-Transistor T1 die Gatespannung $V_G1$ [der Gateanschluss von T1 ist dem ersten Eingangsanschluss In + zugeordnet] kleiner als die Summe der Sourcespannung $V_S1$ und der Transistor-Schwellspannung $V_{thN}$ [der Sourceanschluss von T1 ist der (idealisiert eine verschwindende Impedanz aufweisenden) Konstantstromquelle KQ sowie dem Sourceanschluss des zweiten n-Kanal-Transistors T2 zugeordnet] ist, weist dieser n-Kanal-Transistor T1 einen hohen Widerstand auf und sperrt; entsprechend öffnet sich dieser erste n-Kanal-Transistor T1 und leitet, wenn an diesem ersten n-Kanal-Transistor T1 die Gatespannung $V_G1$ größer als die Summe der Sourcespannung $V_S1$ und der Transistor-Schwellspannung $V_{thN}$ ist.

Durch die differentielle Schaltungsanordnung in Fig. 2B ist ein Wechselschalter realisiert, der ein hartes Umschalten ermöglicht, wobei jeweils einer der beiden Lastwiderstandsknoten nach unten gezogen wird. Nachteilig ist bei der differentiellen Schaltungsanordnung gemäß Fig. 2B jedoch insbesondere die sehr niedrige Leistungseffizienz, bedingt durch eine Stromeffizienz von lediglich etwa 25 Prozent, das heißt nur etwa 25 Prozent des von der Versorgungsspannungsquelle SQ entnommenen Stroms fließen in die zu treibende Datenleitung. Um die gewünschte Stromamplitude auf der Datenleitung zu erreichen, muss daher ein viermal so hoher Strom von der Versorgungsspannung gezogen werden.

In Fig. 2C liefert die (idealisiert eine verschwindende Impedanz aufweisende) Spannungsquelle SQ etwa 2,5 Volt; während es sich bei den beiden Transistoren T2 und T4 um n-Kanal-Transistoren handelt, sind die beiden Transistoren T1 und T3 jeweils ein p-Kanal-Transistor, der einen hohen Widerstand aufweist und sperrt, wenn die Gatespannung $V_G3$ [der Gateanschluss von T1 ist dem ersten Eingangsanschluss In + zugeordnet; der Gateanschluss von T3 ist dem zweiten Eingangsanschluss In - zugeordnet] größer als die Summe der Sourcespannung $V_S3$ und der Transistor-Schwellspannung $V_{thP}$ [der Sourceanschluss von T1 bzw. von T3 ist der Spannungsquelle SQ zugeordnet] ist; entsprechend öffnet sich der p-Kanal-Transistor T1 bzw. T3 infolge eines gegen Null gehenden Widerstands, wenn an T1 bzw. an T3 die Gatespannung kleiner als die Summe der Sourcespannung $V_S3$ und Transistor-Schwellspannung $V_{tnP}$ ist.

Nachteilig ist bei der vom Prinzip her an die Inverterschaltung aus Fig. 2A anknüpfenden differentiellen Schaltungsanordnung gemäß Fig. 2C jedoch insbesondere die niedrige Leistungseffizienz von lediglich etwa fünfzig Prozent, das heißt der von der Spannungsversorgung gezogene Versorgungsstrom ist etwa doppelt so hoch wie der zur Verfügung stehende Ausgangsstrom.

In Fig. 2D haben die beiden Lastwiderstände von jeweils exemplarisch fünfzig Ohm eine terminierende Funktion (in der Praxis betragen die beiden Lastwiderstände jeweils lediglich etwa 47 Ohm, den die Transistoren weisen einen geringen Restwiderstand von jeweils etwa drei Ohm auf, so dass die differentielle Schaltungsanordnung gemäß Fig. 2D Unzulänglichkeiten bezüglich der Präzision der Terminierung hat).

Zwar weist die differentielle Schaltungsanordnung gemäß Fig. 2D eine sehr hohe Leistungseffizienz (Stromeffizienz: nahezu einhundert Prozent) auf; nachteilig ist bei der differentiellen Schaltungsanordnung gemäß Fig. 2D jedoch insbesondere, dass es zu Fehlanpassungen während der Umschaltphasen kommt.

In diesem Zusammenhang ist zu bedenken, dass bei den üblicherweise hohe Datenraten, mit denen die zum Zwecke der Störungsminimierung differentiellen Signale übertragen werden, die Umschaltphasen durchaus etwa zwanzig Prozent bis etwa dreißig Prozent der Gesamtzeit ausmachen können [in der Theorie angenommene ideale 0- und 1-Pulse liegen in der Realität nicht vor, das heißt es ist ein Flankenanstieg bzw. -abfall zwischen dem 0-Zustand (Off-Zustand) und dem 1-Zustand (On-Zustand) zu beobachten].

Mit anderen Worten bedeutet dies, dass die Anstiegszeiten sowie die Abfallzeiten bei hohen Datenraten durchaus relevant sind (und im Sinne der E[lektro-]M[agnetischen]V[erträglichkeit] sogar durchaus nicht unerwünscht sind; bei idealen, das heißt unendlich steilen Flanken [verschwindende Zeitdifferenz] träte eine [nach Fouriertransformation] unendlich hohe Anzahl von Störfrequenzen auf).

Wenn etwa die am p-Kanal-Transistor T1 sowie am n-Kanal-Transistor T2 (gleichzeitig) anliegende Gatespannung von beispielsweise 1,2 Volt auf 0 Volt abfällt, so reagiert der p-Kanal-Transistor T1 bis etwa zur mittleren Phase der abfallenden Spannung, das heißt beispielsweise bei etwa 0,6 Volt, noch nicht, wohingegen der n-Kanal-Transistor T2 in der mittleren Phase der abfallenden Spannung, das heißt bei beispielsweise 0,6 Volt bereits zu sperren beginnt, das heißt eine wesentlich anwachsende Impedanz aufweist. Hierdurch kommt es während der Umschaltflanke zu einer deutlich erhöhten Ausgangsimpedanz, wodurch die Reflexionsdämpfung und die Signalqualität verschlechtert werden.

*Eine derartig deutlich erhöhte Ausgangsimpedanz weist auch die differentielle Treiberschaltungsanordnung gemäß der eingangs zitierten US 2003/0094977A1 auf. Zum technologischen Hintergrund der vorliegenden Erfindung sei ergänzend noch auf die Druckschrift US 6 812 733 B1 aus dem Stand der Technik aufmerksam gemacht.*

### Darstellung der vorliegenden Erfindung: Aufgabe, Lösung, Vorteile

Ausgehend von den vorstehend dargelegten Nachteilen und Unzulänglichkeiten sowie unter Würdigung des umrissenen Standes der Technik liegt der vorliegenden Erfindung die Aufgabe zugrunde, eine Schaltungsanordnung der eingangs genannten Art sowie ein Verfahren der eingangs genannten Art so weiterzubilden, dass während der Umschaltphase eine erhöhte Ausgangsimpedanz vermieden wird und hierdurch eine hohe Signalqualität gewährleistet ist.

Diese Aufgabe wird

- durch eine Schaltungsanordnung mit den im Anspruch 1 angegebenen Merkmalen, insbesondere durch einen leistungseffizienten Leitungstreiber mit kontrollierter Ausgangsimpedanz, sowie

- durch ein Verfahren mit den im Anspruch 6 angegebenen Merkmalen, insbesondere durch ein Verfahren zum Treiben mindestens einer differentiellen Leitung zum Zwecke der reflexionsarmen und fehlerfreien digitalen Datenübertragung

gelöst. Vorteilhafte Ausgestaltungen und zweckmäßige Weiterbildungen der vorliegenden Erfindung sind in den jeweiligen Unteransprüchen gekennzeichnet.

Die vorliegende Schaltungsanordnung, die gemäß dem Verfahren der vorliegenden Erfindung arbeitet, kann mindestens einem, insbesondere am Abschluss oder am Ende mindestens eines Trägermediums, wie etwa mindestens einer Glasfaser, mindestens einer Kunststofffaser oder von Luft, angeordneten lichtempfindlichen Bauelement, zum Beispiel mindestens einer Photodiode, nachgeschaltet sein.

Die vorliegende Erfindung gelangt mit Vorteil

- in mindestens einer, insbesondere mobilen, Telekommunikationsanlage, zum Beispiel in mindestens einem Kommunikationsgerät, wie etwa in mindestens einem Mobiltelefon,
- in mindestens einer, insbesondere mobilen, Datenkommunikationsanlage oder in mindestens einer, insbesondere mobilen, Datenverarbeitungseinrichtung, zum Beispiel in mindestens einem Handheld, in mindestens einem Notebook oder in mindestens einem P[ersonal]D[igital]A[ssistant],
- in mindestens einer, insbesondere mobilen, Datenaufzeichnungs- und/oder -wiedergabeeinrichtung, zum Beispiel in mindestens einem Camcorder, in mindestens einer Digitalkamera oder in mindestens einem H[igh]D[efinition]T[ele]V[ision], oder
- in mindestens einem Fortbewegungsmittel, zum Beispiel in mindestens einem Fahrerassistenzsystem oder in mindestens einem Navigationssystem eines Automobils zur Anwendung.

**Kurze Beschreibung der Zeichnungen**

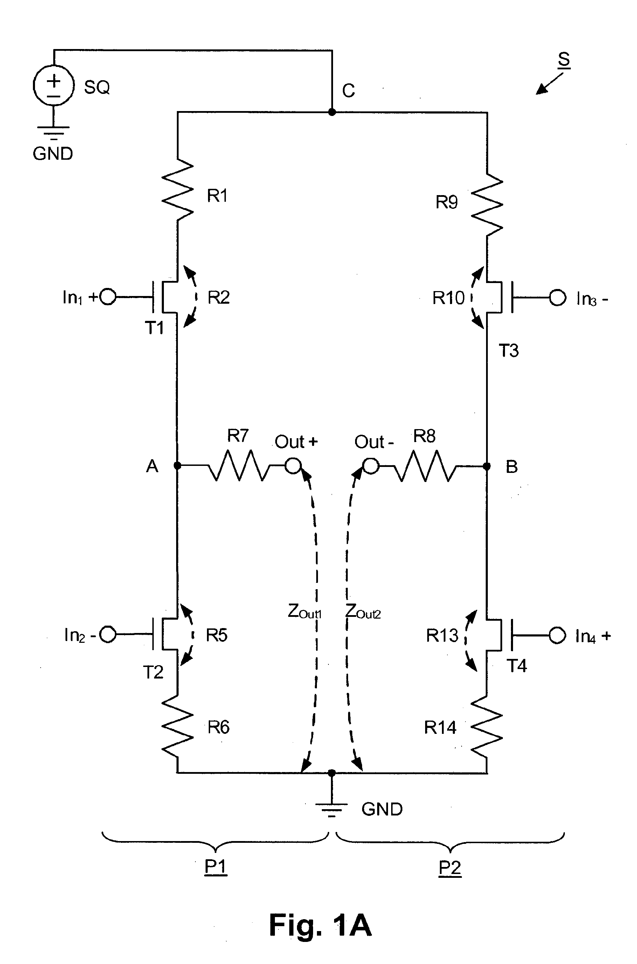

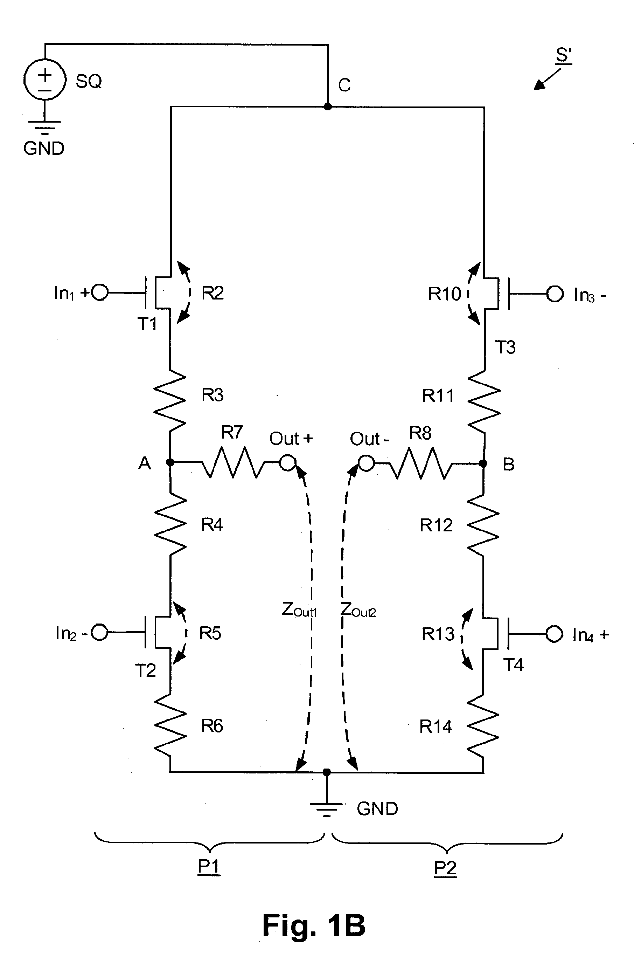

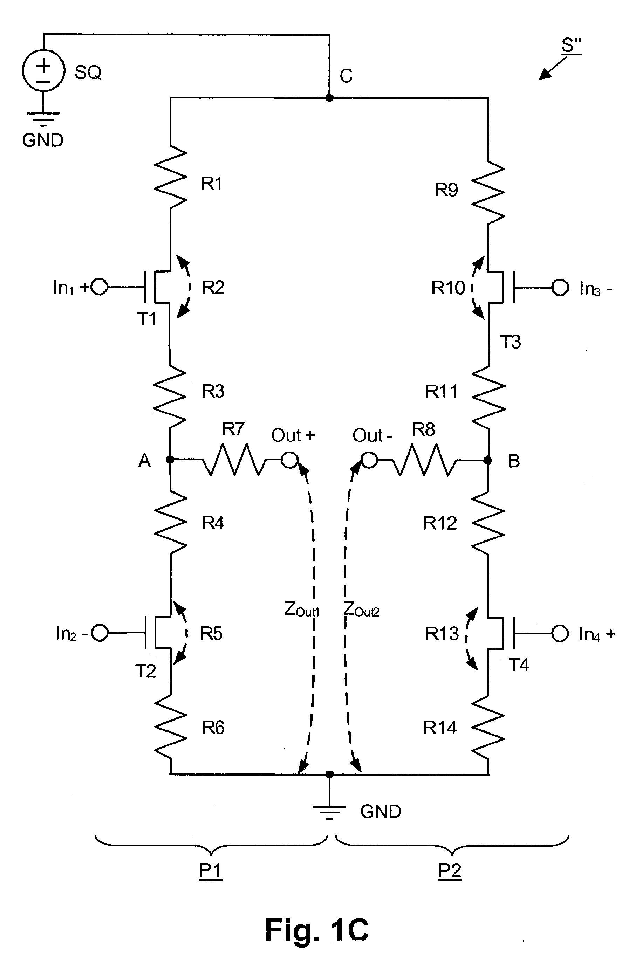

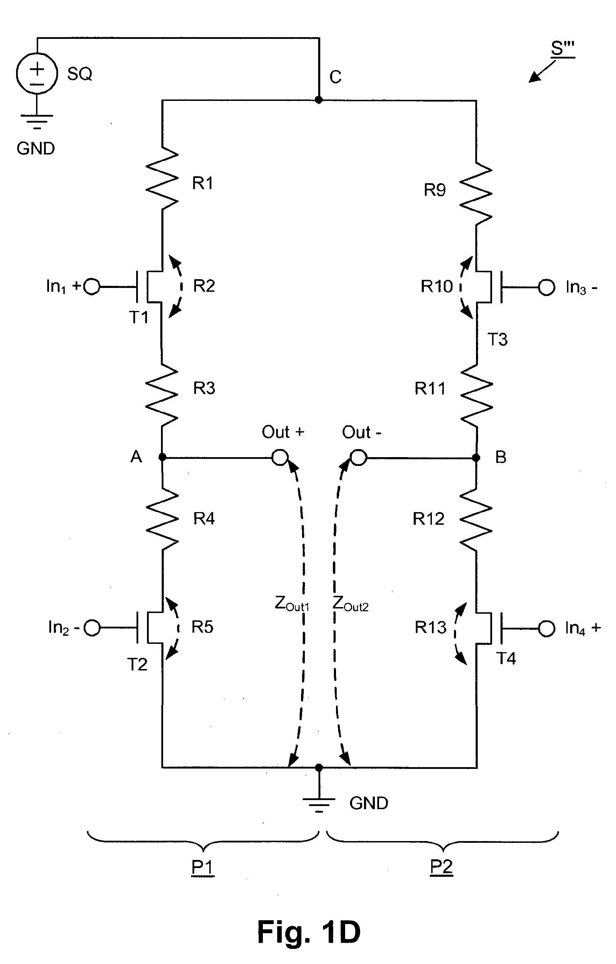

Wie bereits vorstehend erörtert, gibt es verschiedene Möglichkeiten, die Lehre der vorliegenden Erfindung in vorteilhafter Weise auszugestalten und weiterzubilden. Hierzu werden weitere Ausgestaltungen, Merkmale und Vorteile der vorliegenden Erfindung nachstehend unter anderem anhand der vier durch Fig. 1A, durch Fig. 1B, durch Fig. 1C und durch Fig. 1D veranschaulichten Ausführungsbeispiele näher erläutert.

Es zeigt:

Fig. 1A    in schematischer Darstellung ein erstes Ausführungsbeispiel einer Schaltungsanordnung gemäß der vorliegenden Erfindung, die nach dem Verfahren gemäß der vorliegenden Erfindung arbeitet;

Fig. 1B    in schematischer Darstellung ein zweites Ausführungsbeispiel einer Schaltungsanordnung gemäß der vorliegenden Erfindung, die nach dem Verfahren gemäß der vorliegenden Erfindung arbeitet;

Fig. 1C    in schematischer Darstellung ein drittes Ausführungsbeispiel einer Schaltungsanordnung gemäß der vorliegenden Erfindung, die nach dem Verfahren gemäß der vorliegenden Erfindung arbeitet;

Fig. 1D    in schematischer Darstellung ein viertes Ausführungsbeispiel einer Schaltungsanordnung gemäß der vorliegenden Erfindung, die nach dem Verfahren gemäß der vorliegenden Erfindung arbeitet;

Fig. 2A    in schematischer Darstellung ein erstes Beispiel einer Schaltungsanordnung aus dem Stand der Technik, die nach einem ersten Verfahren aus dem Stand der Technik arbeitet;

Fig. 2B    in schematischer Darstellung ein zweites Beispiel einer Schaltungsanordnung aus dem Stand der Technik, die nach einem zweiten Verfahren aus dem Stand der Technik arbeitet;

Fig. 2C    in schematischer Darstellung ein drittes Beispiel einer Schaltungsanordnung aus dem Stand der Technik, die nach einem dritten Verfahren aus dem Stand der Technik arbeitet; und

Fig. 2D    in schematischer Darstellung ein viertes Beispiel einer Schaltungsanordnung aus dem Stand der Technik, die nach einem vierten Verfahren aus dem Stand der Technik arbeitet.

Gleiche oder ähnliche Ausgestaltungen, Elemente oder Merkmale sind in Fig. 1A bis Fig. 2D mit identischen Bezugszeichen versehen.

**Bester Weg zur Ausführung der vorliegenden Erfindung**

Zur Vermeidung überflüssiger Wiederholungen beziehen sich die nachfolgenden Erläuterungen hinsichtlich der Ausgestaltungen, Merkmale und Vorteile der vorliegenden Erfindung - soweit nicht anderweitig angegeben -

- sowohl auf das in Fig. 1A dargestellte erste Ausführungsbeispiel einer Schaltungsanordnung S gemäß der vorliegenden Erfindung
- als auch auf das in Fig. 1B dargestellte zweite Ausführungsbeispiel einer Schaltungsanordnung S' gemäß der vorliegenden Erfindung
- als auch auf das in Fig. 1C dargestellte dritte Ausführungsbeispiel einer Schaltungsanordnung S" gemäß der vorliegenden Erfindung
- als auch auf das in Fig. 1D dargestellte vierte Ausführungsbeispiel einer Schaltungsanordnung S"' gemäß der vorliegenden Erfindung.

Bevor nachstehend die Funktionsweise der (Treiberausgangs-)Schaltungsanordnung S (vgl. Fig. 1A), S' (vgl. Fig. 1B), S" (vgl. Fig. 1C), S"' (vgl. Fig. 1D) erläutert wird, wird zunächst der Aufbau und die Struktur dieser Schaltungen S, S', S", S"' dargelegt:

Die Treiberausgangsschaltungen S, S', S", S"' werden mittels einer zwischen ein Referenzpotential GND (= zum Beispiel Erdpotential oder Massepotential oder Nullpotential) und einen dritten Knoten C (= dritte Verzweigung C) geschalteten Spannungsquelle SQ mit Spannung bzw. mit Strom versorgt und sind zum Treiben einer

- an einen ersten Ausgangsanschluss Out + sowie
- an einen zweiten Ausgangsanschluss Out -

anschließbaren differentiellen Leitung zum Zwecke der digitalen Datenübertragung bestimmt.

Ausgehend vom Knotenpunkt C weist die Schaltungsanordnung S, S', S", S'" zwei spiegelbildlich zueinander angeordnete, die Spannungsquelle SQ mit dem Referenzpotential GND verbindende Pfade P1, P2 auf.

Hierbei weist der erste Pfad P1

- einen ersten Transistor T1 in Form eines n-Kanal-MOSFET (MOSFET = metal oxide semiconductor field-effect transistor = Metall-Oxid-Halbleiter-Feldeffekttransistor), dessen Gateanschluss einem ersten, mit einer ersten Ansteuerspannung beaufschlagten Eingangsanschluss $In_1$ + zugeordnet ist; und
- einen zweiten Transistor T2 in Form eines weiteren n-Kanal-MOSFET, dessen Gateanschluss einem zweiten, mit einer zweiten Ansteuerspannung beaufschlagten Eingangsanschluss $In_2$ - zugeordnet ist, auf, wobei der erste Ausgangsanschluss Out + über einen ersten Knoten A (= erste Verzweigung A) zwischen den ersten Transistor T1 und den zweiten Transistor T2 geschaltet ist.

In spiegelbildlicher Weise weist der zweite Pfad P2

-- einen dritten Transistor T3 in Form eines weiteren n-Kanal-MOSFET, dessen Gateanschluss einem dritten, mit einer dritten Ansteuerspannung beaufschlagten Eingangsanschluss $In_3$ - zugeordnet ist; und

-- einen vierten Transistor T4 in Form eines weiteren n-Kanal-MOSFET, dessen Gateanschluss einem vierten, mit einer vierten Ansteuerspannung beaufschlagten Eingangsanschluss $In_4$ + zugeordnet ist, auf, wobei der zweite Ausgangsanschluss Out - über einen zweiten Knoten B (= zweite Verzweigung B) zwischen den dritten Transistor T3 und den vierten Transistor T4 geschaltet ist.

Beim anhand Fig. 1A veranschaulichten ersten Ausführungsbeispiel der vorliegenden Erfindung ist im ersten Pfad P1 ein zwischen den Knotenpunkt C und den Drainanschluss des ersten Transistors T1 geschalteter erster Draindegradationswiderstand R1, zum Beispiel von etwa zwanzig Ohm, angeordnet.

In spiegelbildlicher Weise ist beim anhand Fig. 1A veranschaulichten ersten Ausführungsbeispiel der vorliegenden Erfindung im zweiten Pfad P2 ein zwischen den Knotenpunkt C und den Drainanschluss des dritten Transistors T3 geschalteter zweiter Draindegradationswiderstand R9, zum Beispiel von etwa zwanzig Ohm, angeordnet.

Diese beiden Draindegradationswiderstände R1 bzw. R9 werden erst dann als Impedanz für den jeweiligen Ausgangsanschluss Out + bzw. Out - wirksam, wenn der erste Transistor T1 bzw. der dritte Transistor T3 durch eine entsprechend hohe Spannung am jeweiligen Gateanschluss in einen sehr niederohmigen, voll durchgesteuerten Betriebszustand (= Betrieb außerhalb der Sättigung) versetzt wird. Hierdurch wird das ansonsten eintretende Absinken der jeweiligen Gesamtausgangsimpedanz $Z_{Out1}$ bzw. $Z_{Out2}$ vermieden.

Beim anhand Fig. 1B veranschaulichten zweiten Ausführungsbeispiel der vorliegenden Erfindung sind im ersten Pfad P1

- ein zwischen den Sourceanschluss des ersten Transistors T1 und den ersten Ausgangsanschluss Out + geschalteter erster Trennwiderstand R3 sowie
- ein zwischen den Drainanschluss des zweiten Transistors T2 und den ersten Ausgangsanschluss Out + geschalteter zweiter Trennwiderstand R4

angeordnet.

Mittels der Trenn- oder Split(ting-)Widerstände R3, R4 können der erste Transistor T1 und der zweite Transistor T2 getrennt oder gesplittet werden und kann unter Beibehaltung der angestrebten ersten Ausgangsimpedanz $Z_{Out1}$ der Wert des zwischen den ersten Knoten A und den (die erste Ausgangsimpedanz $Z_{Out2}$ aufweisenden) ersten Ausgangsanschluss Out + geschalteten ersten Ausgangsserienwiderstands R7 abgesenkt werden; insbesondere dienen die beiden Trennwiderstände R3 und R4

- zum Verringern von während der Umschaltphase fließenden Querströmen (sogenannte shoot-through currents) und
- zum Verringern der ersten Ausgangsimpedanz $Z_{Out1}$ in der Umschaltphase.

In spiegelbildlicher Weise sind im zweiten Pfad P2

- ein zwischen den Sourceanschluss des dritten Transistors T3 und den zweiten Ausgangsanschluss Out - geschalteter dritter Trennwiderstand R11 sowie
- ein zwischen den Drainanschluss des vierten Transistors T4 und den zweiten Ausgangsanschluss Out - geschalteter vierter Trennwiderstand R12

angeordnet.

Mittels der Trenn- oder Split(ting-)Widerstände R11, R12 können der dritte Transistor T3 und der vierte Transistor T4 getrennt oder gesplittet werden und kann unter Beibehaltung der angestrebten zweiten Ausgangsimpedanz $Z_{Out2}$ der Wert des zwischen den zweiten Knoten B und den (die zweite Ausgangsimpedanz $Z_{Out2}$ aufweisenden) zweiten Ausgangsanschluss Out - geschalteten zweiten Ausgangsserienwiderstands R8 abgesenkt werden; insbesondere dienen die beiden Trennwiderstände R11 und R12

- zum Verringern von während der Umschaltphase fließenden Querströmen (sogenannte shoot-through currents) und

- zum Verringern der zweiten Ausgangsimpedanz $Z_{Out2}$ in der Umschaltphase.

Während also beim anhand Fig. 1A veranschaulichten ersten Ausführungsbeispiel der vorliegenden Erfindung die Trennwiderstände R3, R4 bzw. R11, R12 gewissermaßen verschwindend sind, worunter im Rahmen der vorliegenden Erfindung ein Widerstand oder eine Impedanz von weniger als etwa ein Prozent der jeweiligen Ausgangsimpedanz $Z_{Out1}$ bzw. $Z_{Out2}$ verstanden werden soll, sind beim anhand Fig. 1 B veranschaulichten zweiten Ausführungsbeispiel der vorliegenden Erfindung die Draindegradationswiderstände R1 bzw. R9 gewissermaßen verschwindend.

Beim anhand Fig. 1C veranschaulichten dritten Ausführungsbeispiel der vorliegenden Erfindung sind weder die Draindegradationswiderstände R1 bzw. R9 noch die Trennwiderstände R3, R4 bzw. R11, R12 verschwindend; vielmehr sind sowohl die beiden Draindegradationswiderstände R1, R9 als auch die vier Trennwiderstände R3, R4, R11, R12 nicht verschwindend, worunter im Rahmen der vorliegenden Erfindung ein Widerstand oder eine Impedanz von mehr als etwa zehn Prozent der jeweiligen Ausgangsimpedanz $Z_{Out1}$ bzw. $Z_{Out2}$ verstanden werden soll.

Wie der jeweiligen Darstellung der Fig. 1A bzw. der Fig. 1B bzw. der Fig. 1C des Weiteren entnehmbar ist, weist der erste Pfad P1 der differentiellen Schaltungsanordnung S bzw. S' bzw. S" einen zwischen den Sourceanschluss des zweiten Transistors T2 und das Referenzpotential GND geschalteten ersten Sourcedegradationswiderstand R6 auf.

Wie der jeweiligen Darstellung der Fig. 1A bzw. der Fig. 1B bzw. der Fig. 1C des Weiteren entnehmbar ist, weist der zweite Pfad P2 der differentiellen Schaltungsanordnung S bzw. S' bzw. S" in spiegelbildlicher Weise einen zwischen den Sourceanschluss des vierten Transistors T4 und das Referenzpotential GND geschalteten zweiten Sourcedegradationswiderstand R14 auf.

Dieser erste Sourcedegradationswiderstand R6 bzw. dieser zweite Sourcedegradationswiderstand R14 kann allerdings gegen Null gehen, das heißt verschwinden, wenn die Dimensionierung der differentiellen Schaltungsanordnung S"', wie im anhand Fig. 1D veranschaulichten vierten Ausführungsbeispiel einer Schaltungsanordnung S"' gemäß der vorliegenden Erfindung gezeigt, über die beiden n-Kanal-MOSFETs T1, T2 im ersten Pfad P1 bzw. über die beiden n-Kanal-MOSFETs T3, T4 im zweiten Pfad P2 erfolgt.

Wie der jeweiligen Darstellung der Fig. 1A bzw. der Fig. 1B bzw. der Fig. 1C des Weiteren entnehmbar ist, weist der in Fig. 1A bzw. in Fig. 1B bzw. in Fig. 1C linke Teil der differentiellen Schaltungsanordnung S bzw. S' bzw. S" einen zwischen den Sourceanschluss des ersten Transistors T1, den Drainanschluss des zweiten Transistors T2 und den ersten Ausgangsanschluss Out + geschalteten, dem ersten Knoten A zugeordneten ersten Ausgangsserienwiderstand R7 auf.

Wie der jeweiligen Darstellung der Fig. 1A bzw. der Fig. 1B bzw. der Fig. 1C des Weiteren entnehmbar ist, weist der in Fig. 1A bzw. in Fig. 1B bzw. in Fig. 1C linke Teil der differentiellen Schaltungsanordnung S bzw. S' bzw. S" in spiegelbildlicher Weise einen zwischen den Sourceanschluss des dritten Transistors T3, den Drainanschluss des vierten Transistors T4 und den zweiten Ausgangsanschluss Out - geschalteten, dem zweiten Knoten B zugeordneten zweiten Ausgangsserienwiderstand R8 auf.

Dieser erste Ausgangsserienwiderstand R7 bzw. dieser zweite Ausgangsserienwiderstand R8 kann allerdings gegen Null gehen, das heißt verschwinden, wenn die jeweiligen Trennwiderstände R3, R4 im ersten Pfad P1 bzw. die jeweiligen Trennwiderstände R11, R12 im zweiten Pfad P2 hinreichend groß gewählt werden, um die angestrebte gesamte Ausgangsimpedanz $Z_{Out1}$ bzw. $Z_{Out2}$ zu erreichen.

Die (Treiberausgangs-)Schaltungsanordnung S (vgl. Fig. 1A), S' (vgl. Fig. 1B), S" (vgl. Fig. 1C), S"' (vgl. Fig. 1 D) funktioniert wie folgt:

Im Falle positiver Vollaussteuerung, das heißt während die jeweilige Ansteuerspannung zum Beispiel $In_1 + = 1{,}2$ Volt, $In_2 - = 0$ Volt, $In_3 - = 0$ Volt, $In_4 + = 1{,}2$ Volt ist,

- leiten der erste n-Kanal-Transistor T1 sowie der (aufgrund minimaler Spannungsdifferenz etwas kleinere) vierte n-Kanal-Transistor T4 und befinden sich im linearen Bereich, das heißt die Drain-Source-Spannung ist kleiner als die Sättingungsspannung, wobei sich die Sättingungsspannung als Drain-Source Spannung abzüglich der Einsatzspannung $V_{th}$ ergibt, und

- sperren der zweite n-Kanal-Transistor T2 sowie der dritte n-Kanal-Transistor T3.

Die Ausgangsimpedanzen $Z_{Out1}$, $Z_{Out2}$ des Leitungstreibers S (vgl. Fig. 1A), S' (vgl. Fig. 1B), S" (vgl. Fig. 1C) ergeben sich dann zu

$$Z_{Out1} = R1 + R2 + R3 + R7 = Z_{L1}$$

und

$$Z_{Out2} = R8 + R12 + R13 + R14 = Z_{L2}$$

mit $Z_{L1} + Z_{L2} = Z_L$, wobei zum Beispiel $Z_{L1}$ = 50 Ohm und $Z_{L2}$ = 50 Ohm ist.

Im Falle negativer Vollaussteuerung, das heißt während die Ansteuerspannung die umgekehrte Polarität aufweist, also zum Beispiel $In_1$ + = 0 Volt, $In_2$ - = 1,2 Volt, $In_3$ - = 1,2 Volt, $In_4$ + = 0 Volt ist,

- sperren der erste n-Kanal-Transistor T1 sowie der vierte n-Kanal-Transistor T4 und
- leiten der zweite n-Kanal-Transistor T2 sowie der dritte n-Kanal-Transistor T3 und befinden sich im linearen Bereich, das heißt die Drain-Source-Spannung ist kleiner als die Sättingungsspannung, wobei sich die Sättingungsspannung als Drain-Source Spannung abzüglich der Einsatzspannung $V_{th}$ ergibt.

Die Ausgangsimpedanzen $Z_{Out1}$, $Z_{Out2}$ des Leitungstreibers S (vgl. Fig. 1A), S' (vgl. Fig. 1B), S" (vgl. Fig. 1 C) ergeben sich dann zu

$$Z_{Out1} = R7 + R4 + R5 + R6 = Z_{L1}$$

und

$$Z_{Out2} = R9 + R10 + R11 + R8 = Z_{L2}.$$

Hierbei erfüllt grundsätzlich eine Vielzahl von möglichen Werten der Widerstände R1 bis R14 die Bedingung für die Anpassung: $Z_{Out1} = Z_{Out2} = Z_{L1/2}$.

Werden nun die Ausgangsimpedanzen $Z_{Out1}$, $Z_{Out2}$ des Leitungstreibers S (vgl. Fig. 1A), S' (vgl. Fig. 1B), S" (vgl. Fig. 1C) während der Umschaltphase, hier exemplarisch bis zum Mittelpunkt der Schaltflanke, das heißt beispielsweise bei einer Ansteuerspannung von ursprünglich etwa 1,2 Volt auf etwa 0,6 Volt absinkend, betrachtet (die Ausgangsimpedanz kann auch bei jedem anderen beliebigen Arbeitspunkt bestimmt werden), so ergeben sich für diesen Fall die folgenden Zustände (die Spannung am Knoten C ist exemplarisch mit etwa 0,4 Volt angenommen):

Der erste n-Kanal-Transistor T1 befindet sich zu Beginn der Schaltflanke in seinem linearen Bereich (, das heißt beginnt seinen Betrieb gewissermaßen als niederohmiger Schalter in leitendem Zustand), das heißt die Drain-Source-Spannung ist kleiner als die Sättingungsspannung; der äquivalente Drain-Source-Widerstand R2 des ersten n-Kanal-Transistors T1 ist hierdurch sehr niedrig, beispielsweise etwa drei Ohm.

Durch das Absinken der Spannung am ersten Eingangsanschluss $In_1$ + ändert sich der Arbeitspunkt des ersten Transistors T1 vom Betrieb im linearen Bereich, in dem der Draindegradationswiderstand R1 annähernd zu hundert Prozent zur ersten Ausgangsimpedanz $Z_{Out1}$ beiträgt, zum Betrieb als Source-Follower in Sättigung.

Durch diese Änderung wird der erste Draindegradationswiderstand R1 für die erste Ausgangsimpedanz $Z_{Out1}$ nahezu wirkungslos (beispielsweise nur noch etwa zehnprozentiger Beitrag des ersten Draindegradationswiderstands R1 zur ersten Ausgangsimpedanz $Z_{Out1}$), weil der erste n-Kanal-Transistor T1 nun als Source-Follower arbeitet (--> Wirkung für $Z_{Out1}$= R1·$g_{DS}$/$g_m$ + $R2_S$ + R3 + R7, wobei $g_{DS}$ der Drain-Source-Leitwert und $g_m$ die Transkonduktanz ist (die Transkonduktanz $g_m$, auch als Steilheit bezeichnet, ist eine Kenngröße, die das Verhältnis von Ausgangsstrom zu Eingangsspannung angibt); im Beispiel ist $g_{DS}$/$g_m$ etwa gleich 0,1; $R2_S$ ist in guter Näherung gleich $g_m^{-1}$, beträgt etwa fünfzehn Ohm und ist größer als R2 mit etwa drei Ohm).

Gleichzeitig beginnt der in regulärer Source-Schaltung arbeitende zweite n-Kanal-Transistor T2 zu leiten, befindet sich jedoch bis etwa zum exemplarischen Mittelpunkt der Transition, das heißt beispielsweise bei einer Ansteuerspannung von etwa 0,6 Volt noch in seiner Sättigung. Solange sich der zweite n-Kanal-Transistor T2 noch in Sättigung befindet, ist seine Ausgangsimpedanz relativ hoch.

Während dieser Transition ist der zweite Draindegradationswiderstand R9 im Begriffe, von einem für die zweite Ausgangsimpedanz $Z_{Out2}$ wirkungslosen Zustand in einen zur zweiten Ausgangsimpedanz $Z_{Out2}$ zumindest geringfügig beitragenden Zustand überzugehen, wenn sich der Arbeitspunkt des dritten Transistors T3 durch Ansteigen der Ansteuerspannung am dritten Eingangsanschluss $In_3$ - vom Sperrbetrieb zum Betrieb im Sättigungsbereich ändert.

Demzufolge ist zwischen dem Knotenpunkt A und dem Referenzpotential GND (= zum Beispiel Erdpotential oder Nullpotential oder Masse) eine relativ hohe Impedanz, die sich parallel zur Impedanz zwischen Knotenpunkt A und Knotenpunkt C schaltet, jedoch durch ihren hohen Wert wenig Einfluss auf die tatsächliche Ausgangsimpedanz $Z_{Out1}$ hat.

Als Näherung kann der Draindegradationswiderstand R1 zunächst etwa so groß wie die Differenz zwischen R2 (<--> erster Transistor T1 im linearen Betrieb) und $R2_S$ (<--> erster Transistor T1 im Sättigungsbetrieb) gewählt werden, beispielsweise etwa zwölf Ohm. Unter Berücksichtigung des zusätzlichen parallelen Pfads R4 - $R5_S$ - R6 erhöht sich der Draindegradationswiderstand R1 auf beispielsweise etwa zwanzig Ohm.

Durch, zum Beispiel im Wege eines iterativen Verfahrens bewerkstelligte, korrekte Wahl des Draindegradationswiderstands R1 und des ersten Trennwiderstands R3 ist es nun möglich, die Ausgangsimpedanz

$Z_{Out1}$ so einzustellen, das diese auch während der Umschaltphase in guter Näherung den gleichen Wert wie während der Vollaussteuerung beibehält.

Des Weiteren ist für die richtige Einstellung der Widerstände von Bedeutung, dass durch Verkleinern des ersten Ausgangsserienwiderstands R7 und durch gleichzeitiges Vergrößern der beiden Trennwiderstände R3 und R4

- die während der Umschaltphase fließenden Querströme, insbesondere die auftretenden Stromspitzen, verringert werden und
- die Impedanz $Z_{Out1}$ in der Umschaltphase verringert werden kann; für die Vergrößerung der Impedanz $Z_{Out1}$ während der Umschaltphase gilt das Inverse.

Durch diesen Freiheitsgrad lässt sich erreichen, dass für alle anderen Arbeitspunkte $Z_{Out1}$ mit hoher Genauigkeit erreicht wird.

Ein weiterer Freiheitsgrad für die Einstellung der genauen Ausgangsimpedanz $Z_{Out1}$ kann in vorteilhafter Weise dadurch entstehen, dass die Ansteuerung am ersten Eingangsanschluss $In_1$ + und am vierten Eingangsanschluss $In_4$ + zu phasenversetzten Zeitpunkten stattfinden kann und diese Ansteuerungen jeweils angepasste steigende sowie fallende Flanken aufweisen können; dies impliziert eine separate Optimierung von $In_1$ + und von $In_4$ + (für den hier nicht beschriebenen zweiten Eingangsanschluss $In_2$ - und den hier nicht beschriebenen dritten Eingangsanschluss $In_3$ - gilt Analoges).

Für den vorstehend nicht explizit beschriebenen zweiten Pfad P2 der differentiellen Schaltungsanordnung S bzw. S' bzw. S" bzw. S"', das heißt für die rechte Hälfte der Fig. 1A bzw. der Fig. 1B bzw. der Fig. 1C bzw. der Fig. 1D gelten die vorstehenden Erläuterungen entsprechend.

Die vorliegende Erfindung zeichnet sich nicht nur dadurch aus, dass eine niedrige Common-Mode-Ausgangsspannung realisierbar ist; vielmehr ist mit der vorliegenden Erfindung auch ein sehr niedriger Leistungsbedarf erzielbar. Auch während der Umschaltphasen ist eine sehr gute Ausgangsimpedanzanpassung und mithin eine hohe Reflektionsdämpfung erzielbar, wie sie für hohe Datenübertragungsraten vorteilhaft (und erforderlich) ist.

In bevorzugter Weise stellt bei der anhand Fig. 1A bzw. anhand Fig. 1B bzw. anhand Fig. 1C bzw. anhand Fig. 1D veranschaulichten differentiellen Schaltungsanordnung S bzw. S' bzw. S" bzw. S"', die in zweckmäßiger Weise

- mindestens einem lichtempfangenden Bauelement, zum Beispiel mindestens einer Photodiode, nachgeschaltet sein kann und
- kapazitiv gestützt werden kann,

die Spannungsquelle SQ eine Spannung von etwa 0,4 Volt zur Verfügung.

Die vorstehend dargelegte Wahl der Widerstände R1 bis R14 ist zur Anpassung der Ausgangsimpedanzen $Z_{Out1}$, $Z_{Out2}$ für die anzuschließende differentielle Leitung empfehlenswert; die Anordnung der Widerstände kann hierbei zum Beispiel in Form einer (in Fig. 1B bzw. in Fig. 1C gezeigten) Sternschaltung oder auch in Form einer Dreieckschaltung erfolgen.

Die Dimensionierung der differentiellen Schaltungsanordnung S gemäß Fig. 1A bzw. S' gemäß Fig. 1B bzw. S" gemäß Fig. 1C kann erfindungsgemäß auch über die vier n-Kanal-M[etal-]O[xide]S[emiconductor]-Transistoren T1, T2, T3, T4 erfolgen; so können/kann beispielsweise der erste Sourcedegradationswiderstand R6 und/oder der zweite Sourcedegradationswiderstand R14 gegen Null gehen.

In bevorzugter Weise wird die vorliegende Erfindung beim Treiben von Leitungen mit bestimmter Leitungsimpedanz zum Zwecke der reflexionsarmen und fehlerfreien digitalen Datenübertragung von mindestens einer Datenquelle, zum Beispiel von mindestens einer ersten integrierten Schaltung, zu mindestens einer Datensenke, zum Beispiel zu mindestens einer zweiten integrierten Schaltung, eingesetzt.

## Bezugszeichenliste

A erster Knoten oder erster Knotenpunkt oder erste Verzweigung oder erster Verzweigungspunkt

B zweiter Knoten oder zweiter Knotenpunkt oder zweite Verzweigung oder zweiter Verzweigungspunkt

C dritter Knoten oder dritter Knotenpunkt oder dritte Verzweigung oder dritter Verzweigungspunkt

GND Referenzpotential, insbesondere Erdpotential oder Massepotential oder Nullpotential

In + mit Ansteuerspannung beaufschlagbarer Eingangsanschluss (= Beispiel aus dem Stand der Technik; vgl. Fig. 2A), insbesondere mit erster Ansteuerspannung beaufschlagbarer erster Eingangsanschluss (= Beispiel aus dem Stand der Technik; vgl. Fig. 2B, Fig. 2C, Fig. 2D)

In - mit zweiter Ansteuerspannung beaufschlagbarer zweiter Eingangsanschluss (= Beispiel aus dem Stand der Technik; vgl. Fig. 2B, Fig. 2C, Fig. 2D)

$In_1$ + mit erster Ansteuerspannung beaufschlagbarer erster Eingangsanschluss

$In_2$ - mit zweiter Ansteuerspannung beaufschlagbarer zweiter Eingangsanschluss

$In_3$ - mit dritter Ansteuerspannung beaufschlagbarer dritter Eingangsanschluss

$In_4$ + mit vierter Ansteuerspannung beaufschlagbarer vierter Eingangsanschluss

KQ Konstantstromquelle (= Beispiel aus dem Stand der Technik; vgl. Fig. 2B, Fig. 2C)

Out +      erster Ausgangsanschluss

Out -      Ausgangsanschluss (= Beispiel aus dem Stand der Technik; vgl. Fig. 2A) oder zweiter Ausgangsanschluss

P1      erster Pfad, insbesondere erster Signalpfad

P2      zweiter Pfad, insbesondere zweiter Signalpfad

R1      erster Draindegradationswiderstand

R2      Drain-Source-Widerstand des ersten Transistors T1

$R2_S$      Drain-Source-Widerstand des ersten Transistors T1 im Sättigungsbereich

R3      erster Splitwiderstand oder erster Trennwiderstand

R4      zweiter Splitwiderstand oder zweiter Trennwiderstand

R5      Drain-Source-Widerstand des zweiten Transistors T2

$R5_S$      Drain-Source-Widerstand des zweiten Transistors T2 im Sättigungsbereich

R6      erster Sourcedegradationswiderstand

R7      erster Ausgangsserienwiderstand

R8      zweiter Ausgangsserienwiderstand

R9      zweiter Draindegradationswiderstand

R10      Drain-Source-Widerstand des dritten Transistors T3

$R10_S$      Drain-Source-Widerstand des dritten Transistors T3 im Sättigungsbereich

R11      dritter Splitwiderstand oder dritter Trennwiderstand

R12      vierter Splitwiderstand oder vierter Trennwiderstand

R13      Drain-Source-Widerstand des vierten Transistors T4

$R13_S$      Drain-Source-Widerstand des vierten Transistors T4 im Sättigungsbereich

R14      zweiter Sourcedegradationswiderstand

S      Schaltungsanordnung, insbesondere Leitungstreiber oder Treiberausgangsstufe (= erstes Ausführungsbeispiel; vgl. Fig. 1A)

S'      Schaltungsanordnung, insbesondere Leitungstreiber oder Treiberausgangsstufe (= zweites Ausführungsbeispiel; vgl. Fig. 1B)

S"      Schaltungsanordnung, insbesondere Leitungstreiber oder Treiberausgangsstufe (= drittes Ausführungsbeispiel; vgl. Fig. 1C)

S'''      Schaltungsanordnung, insbesondere Leitungstreiber oder Treiberausgangsstufe (= viertes Ausführungsbeispiel; vgl. Fig. 1D)

SQ      Spannungsquelle

T1      erster Transistor, insbesondere erster M[etal-]O[xide]S[emiconductor-]F[ield-]E[ffect]T[ransistor], zum Beispiel erster p-Kanal-MOSFET (= Beispiel aus dem Stand der Technik; vgl. Fig. 2A, Fig. 2C, Fig. 2D) oder erster n-Kanal-MOSFET

T2      zweiter Transistor, insbesondere zweiter M[etal-]O[xide]S[emiconductor-]F[ield-]E[ffect]T[ransistor], zum Beispiel zweiter n-Kanal-MOSFET

T3      dritter Transistor, insbesondere dritter M[etal-]O[xide]S[emiconductor-IF[ield-]E[ffect]T[ransistor], zum Beispiel dritter p-Kanal-MOSFET (= Beispiel aus dem Stand der Technik; vgl. Fig. 2C, Fig. 2D) oder dritter n-Kanal-MOSFET

T4      vierter Transistor, insbesondere vierter M[etal-]O[xide]S[emiconductor-]F[ield-]E[ffect]T[ransistor], zum Beispiel vierter n-Kanal-MOSFET

$Z_L$      Leitungsimpedanz, insbesondere Leitungseingangsimpedanz (= Beispiel aus dem Stand der Technik; vgl. Fig. 2A, Fig. 2B, Fig. 2C, Fig. 2D)

$Z_{Out}$      Ausgangsimpedanz (= Beispiel aus dem Stand der Technik; vgl. Fig. 2A, Fig. 2B, Fig. 2C, Fig. 2D)

$Z_{L1}$      erste Leitungsimpedanz, insbesondere erste Leitungseingangsimpedanz

$Z_{L2}$      zweite Leitungsimpedanz, insbesondere zweite Leitungseingangsimpedanz

$Z_{Out1}$      erste Ausgangsimpedanz

$Z_{Out2}$      zweite Ausgangsimpedanz

**Patentansprüche**

1.    Mittels mindestens einer Spannungsquelle (SQ) versorgbare Schaltungsanordnung (S"; S''') zum Treiben mindestens einer

     - an mindestens einem ersten Ausgangsanschluss (Out +) sowie
     - an mindestens einem zweiten Ausgangsanschluss (Out -)
     anschließbaren differentiellen Leitung zum Zwecke der digitalen Datenübertragung, wobei die Schaltungsanordnung (S"; S''') mindestens zwei spiegelbildlich zueinander angeordnete, die Spannungsquelle (SQ) mit mindestens einem Referenzpotential (GND) verbindende Pfade (P1, P2) aufweist,
     - wobei der erste Pfad (P1)

         -- mindestens einen ersten Transistor (T1), dessen Gateanschluss mindestens einem ersten Eingangsanschluss ($In_1$ +) zugeordnet ist; und
         -- mindestens einen zweiten Transistor (T2), dessen Gateanschluss mindestens einem zweiten Eingangsanschluss ($In_2$ -) zugeordnet ist,
         aufweist,

     wobei der erste Ausgangsanschluss (Out +) zwischen den ersten Transistor (T1) und den zweiten Transistor (T2) geschaltet ist,

- wobei der zweite Pfad (P2)

-- mindestens einen dritten Transistor (T3), dessen Gateanschluss mindestens einem dritten Eingangsanschluss ($In_3$ -) zugeordnet ist; und

-- mindestens einen vierten Transistor (T4), dessen Gateanschluss mindestens einem vierten Eingangsanschluss ($In_4$ +) zugeordnet ist,

aufweist,

wobei der zweite Ausgangsanschluss (Out -) zwischen den dritten Transistor (T3) und den vierten Transistor (T4) geschaltet ist, **dadurch gekennzeichnet,**

- **dass** im ersten Pfad (P1)

-- mindestens ein zwischen die Spannungsquelle (SQ) und den Drainanschluss des ersten Transistors (T1) geschalteter erster Draindegradationswiderstand (R1) angeordnet ist und

-- mindestens ein zwischen den Sourceanschluss des ersten Transistors (T1) und den ersten Ausgangsanschluss (Out +) geschalteter erster Trennwiderstand (R3) sowie mindestens ein zwischen den Drainanschluss des zweiten Transistors (T2) und den ersten Ausgangsanschluss (Out +) geschalteter zweiter Trennwiderstand (R4) angeordnet sind und

- **dass** im zweiten Pfad (P2)

-- mindestens ein zwischen die Spannungsquelle (SQ) und den Drainanschluss des dritten Transistors (T3) geschalteter zweiter Draindegradationswiderstand (R9) angeordnet ist und

-- mindestens ein zwischen den Sourceanschluss des dritten Transistors (T3) und den zweiten Ausgangsanschluss (Out -) geschalteter dritter Trennwiderstand (R11) sowie mindestens ein zwischen den Drainanschluss des vierten Transistors (T4) und den zweiten Ausgangsanschluss (Out -) geschalteter vierter Trennwiderstand (R12) angeordnet sind.

2. Schaltungsanordnung gemäß Anspruch 1, **dadurch gekennzeichnet,**

- **dass** der erste Trennwiderstand (R3) und der zweite Trennwiderstand (R4) zwischen den Sourceanschluss des ersten Transistors (T1) und den Drainanschluss des zweiten Transistors (T2) geschaltet sind und

- **dass** der dritte Trennwiderstand (R11) und der vierte Trennwiderstand (R12) zwischen den Sourceanschluss des dritten Transistors (T3) und den Drainanschluss des vierten Transistors (T4) geschaltet sind.

3. Schaltungsanordnung gemäß Anspruch 1 oder 2, **gekennzeichnet**

- **durch** mindestens einen zwischen den Sourceanschluss des zweiten Transistors (T2) und das Referenzpotential (GND) geschalteten ersten Sourcedegradationswiderstand (R6) und
- **durch** mindestens einen zwischen den Sourceanschluss des vierten Transistors (T4) und das Referenzpotential (GND) geschalteten zweiten Sourcedegradationswiderstand (R14).

4. Schaltungsanordnung gemäß mindestens einem der Ansprüche 1 bis 3, **gekennzeichnet**

- **durch** mindestens einen zwischen den ersten Transistor (T1), den zweiten Transistor (T2) und den ersten Ausgangsanschluss (Out +) geschalteten ersten Ausgangsserienwiderstand (R7) und
- **durch** mindestens einen zwischen den dritten Transistor (T3), den vierten Transistor (T4) und den zweiten Ausgangsanschluss (Out -) geschalteten zweiten Ausgangsserienwiderstand (R8).

5. Schaltungsanordnung gemäß Anspruch 4, **dadurch gekennzeichnet,**

- **dass** der erste Ausgangsserienwiderstand (R7) zwischen den Sourceanschluss des ersten Transistors (T1), den Drainanschluss des zweiten Transistors (T2) und den ersten Ausgangsanschluss (Out +) geschaltet ist und
- **dass** der zweite Ausgangsserienwiderstand (R8) zwischen den Sourceanschluss des dritten Transistors (T3), den Drainanschluss des vierten Transistors (T4) und den zweiten Ausgangsanschluss (Out -) geschaltet ist.

6. Verfahren zum Treiben mindestens einer differentiellen Leitung mittels mindestens einer Schaltungsanordnung (S"; S''') gemäß mindestens einem der Ansprüche 1 bis 5,

- wobei im Bereich positiver Vollaussteuerung

-- der erste Transistor (T1) sowie der vierte Transistor (T4) sich im linearen Bereich befinden und leiten und

-- der zweite Transistor (T2) sowie der dritte Transistor (T3) sperren,

- wobei im Bereich negativer Vollaussteuerung

-- der erste Transistor (T1) sowie der vierte Transistor (T4) sperren und
-- der zweite Transistor (T2) sowie der dritte Transistor (T3) sich im linearen Bereich befinden und leiten und

- wobei im Übergangsbereich zwischen positiver Vollaussteuerung und negativer Vollaussteuerung

-- sich der Arbeitspunkt des ersten Transistors (T1) durch Absinken der Eingangsspannung am ersten Eingangsanschluss (In$_1$ +) vom Betrieb im linearen Bereich zum Betrieb in Sättigung ändert,
-- der zweite Transistor (T2) bei Ansteigen der Eingangsspannung am zweiten Eingangsanschluss (In$_2$ -) bis etwa zum Mittelpunkt des Übergangsbereichs noch in Sättigung bleibt,
-- der dritte Transistor (T3) bei Ansteigen der Eingangsspannung am dritten Eingangsanschluss (In$_3$ -) bis etwa zum Mittelpunkt des Übergangsbereichs noch in Sättigung bleibt und
-- sich der Arbeitspunkt des vierten Transistors (T4) durch Absinken der Eingangsspannung am vierten Eingangsanschluss (In$_4$ +) vom Betrieb im linearen Bereich zum Betrieb in Sättigung ändert.

**7.** Verfahren gemäß Anspruch 6, **dadurch gekennzeichnet,**

- **dass** bei positiver Vollaussteuerung die jeweilige Ansteuerspannung

-- für den ersten Eingangsanschluss (In$_1$ +) etwa 1,2 Volt,
-- für den zweiten Eingangsanschluss (In$_2$ +) etwa 0 Volt,
-- für den dritten Eingangsanschluss (In$_3$ +) etwa 0 Volt und
-- für den vierten Eingangsanschluss (In$_4$ +) etwa 1,2 Volt beträgt und

- **dass** bei negativer Vollaussteuerung die jeweilige Ansteuerspannung

-- für den ersten Eingangsanschluss (In$_1$ +) etwa 0 Volt,
-- für den zweiten Eingangsanschluss (In$_2$ +) etwa 1,2 Volt,
-- für den dritten Eingangsanschluss (In$_3$ +) etwa 1,2 Volt und
-- für den vierten Eingangsanschluss (In$_4$ +)

etwa 0 Volt beträgt.

**8.** Verfahren gemäß Anspruch 6 oder 7, **dadurch gekennzeichnet,**

- **dass** der erste Draindegradationswiderstand (R1) etwa so groß wie die Differenz zwischen dem Drain-Source-Widerstand (R2) des ersten Transistors (T1) im linearen Bereich und dem Drain-Source-Widerstand (R2$_S$) des ersten Transistors (T1) im Sättigungsbereich ist und sich unter Berücksichtigung des parallelen Zweigs aus zweitem Trennwiderstand (R4), Drain-Source-Widerstand (R5$_S$) des zweiten Transistors (T2) im Sättigungsbereich und erstem Sourcedegradationswiderstand (R6) erhöht und
- **dass** der zweite Draindegradationswiderstand (R9) etwa so groß wie die Differenz zwischen dem Drain-Source-Widerstand (R10) des dritten Transistors (T3) im linearen Bereich und dem Drain-Source-Widerstand (R10$_S$) des dritten Transistors (T3) im Sättigungsbereich ist und sich unter Berücksichtigung des parallelen Zweigs aus viertem Trennwiderstand (R12), Drain-Source-Widerstand (R13$_S$) des vierten Transistors (T4) im Sättigungsbereich und zweitem Sourcedegradationswiderstand (R14) erhöht.

**9.** Verfahren gemäß mindestens einem der Ansprüche 6 bis 8, **dadurch gekennzeichnet,**

- **dass** der erste Draindegradationswiderstand (R1) für die erste Ausgangsimpedanz (Z$_{Out1}$) nahezu wirkungslos wird, wenn sich der Arbeitspunkt des ersten Transistors (T1) durch Absinken der Eingangsspannung am ersten Eingangsanschluss (In$_1$ +) vom Betrieb im linearen Bereich zum Betrieb im Sättigungsbereich ändert, und
- **dass** der zweite Draindegradationswiderstand (R9) im Begriffe ist, von einem für die zweite Ausgangsimpedanz (Z$_{Out2}$) wirkungslosen Zustand in einen zur zweiten Ausgangsimpedanz (Z$_{Out2}$) geringfügig beitragenden Zustand überzugehen, wenn sich der Arbeitspunkt des dritten Transistors (T3) durch Ansteigen der Eingangsspannung am dritten Eingangsanschluss (In$_3$ -) vom Sperrbetrieb zum Betrieb im Sättigungsbereich ändert.

**10.** Verfahren gemäß mindestens einem der Ansprüche 6 bis 9, **dadurch gekennzeichnet,**

- **dass** durch Vergrößern des ersten Trennwiderstands (R3) und des zweiten Trennwiderstands (R4) im Übergangsbereich im ersten Pfad (P1) fließende Querströme verringert werden und
- **dass** durch Vergrößern des dritten Trennwiderstands (R11) und des vierten Trennwiderstands (R12) im Übergangsbereich im zweiten Pfad (P2) fließende Querströme verringert werden.

11. Verfahren gemäß mindestens einem der Ansprüche 6 bis 10, **dadurch gekennzeichnet,**

    - **dass** durch Verkleinern des ersten Ausgangsserienwiderstands (R7) im Übergangsbereich die erste Ausgangsimpedanz ($Z_{Out1}$) verringert wird und
    - **dass** durch Verkleinern des zweiten Ausgangsserienwiderstands (R8) im Übergangsbereich die zweite Ausgangsimpedanz ($Z_{Out2}$) verringert wird.

12. Verfahren gemäß mindestens einem der Ansprüche 6 bis 11, **dadurch gekennzeichnet,**

    - **dass** der erste Eingangsanschluss ($In_1$ +) und der vierte Eingangsanschluss ($In_4$ +) phasenversetzt angesteuert werden und
    - **dass** der zweite Eingangsanschluss ($In_2$ -) und der dritte Eingangsanschluss ($In_3$ -) phasenversetzt angesteuert werden.

**Claims**

1. A circuit arrangement (S"; S''') which can be supplied by means of at least one voltage source (SQ) for driving at least one differential line which can be connected

    - to at least one first output connection (Out +) and
    - to at least one second output connection (Out -) for the purpose of digital data transmission, wherein the circuit arrangement (S"; S''') comprises at least two paths (P1, P2) which are arranged in a mirror-image fashion relative to one another and which connect the voltage source (SQ) to at least one reference potential (GND),
    - wherein the first path (P1) comprises

        -- at least one first transistor (T1) whose gate connection is assigned to at least one first input connection ($In_1$ +); and
        -- at least one second transistor (T2) whose gate connection is assigned to at least one second input connection ($In_2$ -), wherein the first output connection (Out +) is connected between the first transistor (T1) and the second transistor (T2),

    - wherein the second path (P2) comprises

        -- at least one third transistor (T3) whose gate connection is assigned to at least one third input connection ($In_3$ -); and
        -- at least one fourth transistor (T4) whose gate connection is assigned to at least one fourth input connection ($In_4$ +), wherein the second output connection (Out -) is connected between the third transistor (T3) and the fourth transistor (T4), **characterized in**

    - **that** in the first path (P1)

        -- there is provided at least one first drain degradation resistance (R1) connected between the voltage source (SQ) and the drain connection of the first transistor (T1) and
        -- at least one first separating resistance (R3) connected between the source connection of the first transistor (T1) and the first output connection (Out +), and at least one second separating resistance (R4) connected between the drain connection of the second transistor (T2) and the first output connection (Out +), and

    - **that** in the second path (P2)

        -- there is provided at least one second drain degradation resistance (R9) connected between the voltage source (SQ) and the drain connection of the third transistor (T3) and
        -- at least one third separating resistance (R11) connected between the source connection of the third transistor (T3) and the second output connection (Out -), and at least one fourth separating resistance (R12) connected between the drain connection of the fourth transistor (T4) and the second output connection (Out -).

2. The circuit arrangement according to claim 1, **characterized in**

    - **that** the first separating resistance (R3) and the second separating resistance (R4) are connected between the source connection of the first transistor (T1) and the drain connection of the second transistor (T2) and
    - **that** the third separating resistance (R11) and the fourth separating resistance (R12) are connected between the source connection of the third transistor (T3) and the drain connection of the fourth transistor (T4).

3. The circuit arrangement according to claim 1 or 2, **characterized**

- **by** at least one first source degradation resistance (R6) connected between the source connection of the second transistor (T2) and the reference potential (GND) and
- by at least one second source degradation resistance (R14) connected between the source connection of the fourth transistor (T4) and the reference potential (GND).

4. The circuit arrangement according to at least one of claims 1 to 3, **characterized**

- **by** at least one first output series resistance (R7) connected between the first transistor (T1), the second transistor (T2) and the first output connection (Out +) and
- by at least one second output series resistance (R8) connected between the third transistor (T3), the fourth transistor (T4) and the second output connection (Out -).

5. The circuit arrangement according to claim 4, **characterized in**

- **that** the first output series resistance (R7) is connected between the source connection of the first transistor (T1), the drain connection of the second transistor (T2) and the first output connection (Out +) and
- **that** the second output series resistance (R8) is connected between the source connection of the third transistor (T3), the drain connection of the fourth transistor (T4) and the second output connection (Out -).

6. A method for driving at least one differential line by means of at least one circuit arrangement (S''; S''') according to at least one of claims 1 to 5,

- wherein in the range of positive full-signal operation

-- the first transistor (T1) and the fourth transistor (T4) are in the linear region and conduct and
-- the second transistor (T2) and the third transistor (T3) are in the off-state,

- wherein in the range of negative full-signal operation

-- the first transistor (T1) and the fourth transistor (T4) are in the off-state and
-- the second transistor (T2) and the third transistor (T3) are in the linear region and conduct and

- wherein in the transition range between positive full-signal operation and negative full-signal operation,

-- due to decrease of the input voltage at the first input connection ($In_1$ +), the operating point of the first transistor (T1) changes from operation in the linear region to operation in saturation,
-- the second transistor (T2) still remains in saturation when the input voltage at the second input connection ($In_2$ -) increases as far as about the central point of the transition range,
-- the third transistor (T3) still remains in saturation when the input voltage at the third input connection ($In_3$ -) increases as far as about the central point of the transition range, and
-- due to decrease of the input voltage at the fourth input connection ($In_4$ +), the operating point of the fourth transistor (T4) changes from operation in the linear region to operation in saturation.

7. The method according to claim 6, **characterized in**

- **that** in the case of positive full-signal operation, the respective control voltage is

-- about 1.2 Volt for the first input connection ($In_1$ +),
-- about 0 Volt for the second input connection ($In_2$ -),
-- about 0 Volt for the third input connection ($In_3$ -), and
-- about 1.2 Volt for the fourth input connection ($In_4$ +), and

- **that** in the case of negative full-signal operation, the respective control voltage is

-- about 0 Volt for the first input connection ($In_1$ +),
-- about 1.2 Volt for the second input connection ($In_2$ -),
-- about 1.2 Volt for the third input connection ($In_3$ -), and
-- about 0 Volt for the fourth input connection ($In_4$ +).

8. The method according to claim 6 or 7, **characterized in**

- **that** the first drain degradation resistance (R1) is approximately as large as the difference between the drain-source resistance (R2) of the first transistor (T1) in the linear region and the drain-source resistance (R2$_S$) of the first transistor (T1) in the saturation region, and is increased taking into account the parallel branch of second separating resistance (R4), drain-source resistance (R5$_S$) of the second transistor (T2) in the saturation region and first source degradation resistance (R6), and

- **that** the second drain degradation resistance (R9) is approximately as large as the difference between the drain-source resistance (R10) of the third transistor (T3) in the linear region and the drain-source resistance (R10$_S$) of the third transistor (T3) in the saturation region, and is increased taking into account the parallel branch of fourth separating resistance (R12), drain-source resistance (R13$_S$) of the fourth transistor (T4) in the saturation region and second source degradation resistance (R14).

9. The method according to at least one of claims 6 to 8, **characterized in**

- **that** the first drain degradation resistance (R1) for the first output impedance (Z$_{Out1}$) is almost ineffective when the operating point of the first transistor (T1) changes from operation in the linear region to operation in the saturation region due to decrease of the input voltage at the first input connection (In$_1$ +), and
- **that** the second drain degradation resistance (R9) is in the course of going over from an ineffective state for the second output impedance (Z$_{Out2}$) into a state contributing slightly to the second output impedance (Z$_{Out2}$) when the operating point of the third transistor (T3) changes from the off-state to operation in the saturation region due to increase of the input voltage at the third input connection (In$_3$ -).

10. The method according to at least one of claims 6 to 9, **characterized in**

- **that** by increasing the first separating resistance (R3) and the second separating resistance (R4) in the transition region, transverse currents flowing in the first path (P1) are reduced, and
- **that** by increasing the third separating resistance (R11) and the fourth separating resistance (R12) in the transition region, transverse currents flowing in the second path (P2) are reduced.

11. The method according to at least one of claims 6 to 10, **characterized in**

- **that** by reducing the first output series resistance (R7) in the transition region, the first output impedance (Z$_{Out1}$) is reduced, and

- **that** by reducing the second output series resistance (R8) in the transition region, the second output impedance (Z$_{Out2}$) is reduced.

12. The method according to at least one of claims 6 to 11, **characterized in**

- **that** the first input connection (In$_1$ +) and the fourth input connection (In$_4$ +) are controlled in a phase-shifted manner, and
- **that** the second input connection (In$_2$ -) and the third input connection (In$_3$ -) are controlled in a phase-shifted manner.

**Revendications**

1. Circuit (S"; S"') pouvant être alimenté à l'aide d'au moins une source de tension (SQ) pour exciter au moins un conducteur différentiel pouvant être raccordé

- à au moins une première borne de sortie (Out +) ainsi
- qu'à au moins une deuxième borne de sortie (Out -)

en vue de la transmission de données numérique, le circuit (S"; S"') présentant au moins deux chemins (P1, P2) disposés en symétrie spéculaire l'un par rapport à l'autre et reliant la source de tension (SQ) à au moins un potentiel de référence (GND),

- moyennant quoi le premier chemin (P1) présente

-- au moins un premier transistor (T1) dont la borne de grille est associée à au moins une première borne d'entrée (In$_1$ +); et
-- au moins un deuxième transistor (T2), dont la borne de grille est associée à au moins une deuxième borne d'entrée (In$_2$ -), la première borne de sortie (Out +) étant couplée entre le premier transistor (T1) et le deuxième transistor (T2),

- moyennant quoi le deuxième chemin (P2) présente

-- au moins un troisième transistor (T3) dont la borne de grille est associée à au moins une troisième borne d'entrée (In$_3$ -); et
-- au moins un quatrième transistor (T4) dont la borne de grille est associée à au moins une quatrième borne d'entrée (In$_4$ +), moyennant quoi la deuxième borne de sortie (Out -) est couplée entre le troisième transistor (T3) et le quatrième transistor (T4),

**caractérisé en ce que,**

- dans le premier chemin (P1)

-- est disposée au moins une première résistance de dégradation de drain (R1) couplée entre la source de tension (SQ) et la borne de drain du premier transistor (T1) et
-- au moins une première résistance de séparation (R3) couplée entre la borne de source du premier transistor (T1) et la première borne de sortie (Out +) ainsi qu'au moins une deuxième résistance de séparation (R4) couplée entre la borne de drain du deuxième transistor (T2) et la première borne de sortie (Out +), étant disposées, et

- **en ce que** dans le deuxième chemin (P2)

-- est disposée au moins une deuxième résistance de dégradation de drain (R9) couplée entre la source de tension (SQ) et la borne de drain du troisième transistor (T3), et
-- au moins une troisième résistance de séparation (R11) couplée entre la borne de source du troisième transistor (T3) et la deuxième borne de sortie (Out -) ainsi qu'au moins une quatrième résistance de séparation (R12) couplée entre la borne de drain du quatrième transistor (T4) et la deuxième borne de sortie (Out -), étant disposées.

**2.** Circuit selon la revendication 1, **caractérisé en ce que**

- la première résistance de séparation (R3) et la deuxième résistance de séparation (R4) sont couplées entre la borne de source du premier transistor (T1) et la borne de drain du deuxième transistor (T2), et
- **en ce que** la troisième résistance de séparation (R11) et la quatrième résistance de séparation (R12) sont couplées entre la borne de source du troisième transistor (T3) et la borne de drain du quatrième transistor (T4).

**3.** Circuit selon les revendications 1 ou 2, **caractérisé par**

- au moins une première résistance de dégradation de source (R6) couplée entre la borne de source du deuxième transistor (T2) et le potentiel de référence (GND), et par
- au moins une deuxième résistance de dégradation de source (R14) couplée entre la borne de source du quatrième transistor (T4) et le potentiel de référence (GND).

**4.** Circuit selon l'une au moins des revendications 1 à 3, **caractérisé par**

- au moins une première résistance série de sortie (R7) couplée entre le premier transistor (T1), le deuxième transistor (T2) et la première borne de sortie (Out +), et par
- au moins une deuxième résistance série de sortie (R8) couplée entre le troisième transistor (T3), le quatrième transistor (T4) et la deuxième borne de sortie (Out -).

**5.** Circuit selon la revendication 4, **caractérisé en ce que**

- la première résistance série de sortie (R7) est couplée entre la borne de source du premier transistor (T1), la borne de drain du deuxième transistor (T2) et la première borne de sortie (Out +), et **en ce que**
- la deuxième résistance série de sortie (R8) est couplée entre la borne de source du troisième transistor (T3), la borne de drain du quatrième transistor (T4) et la deuxième borne de sortie (Out -).

**6.** Procédé pour l'excitation d'au moins un conducteur différentiel à l'aide d'au moins un circuit (S"; S''') selon l'une au moins des revendications 1 à 5,

- dans lequel, dans la plage d'un régime maximal positif

-- le premier transistor (T1) tout comme le quatrième transistor (T4) se trouvent dans la plage linéaire et sont passants, et
-- le deuxième transistor (T2) ainsi que le troisième transistor (T3) étant non passants,

- moyennant quoi, dans la plage d'un régime maximal négatif

-- le premier transistor (T1) tout comme le quatrième transistor (T4) sont non passants, et
-- le deuxième transistor (T2) tout comme le troisième transistor (T3) se trouvant dans la plage linéaire et étant passants, et

- moyennant quoi, dans la plage de transition entre le régime maximal positif et le régime maximal négatif,

-- le point de fonctionnement dynamique du premier transistor (R1) varie par abaissement de la tension d'entrée à la première borne d'entrée (In$_1$ +), du fonctionnement

dans la plage linéaire jusqu'au fonctionnement en saturation,

-- lors de l'élévation de la tension d'entrée à la deuxième borne d'entrée ($In_2$ -), le deuxième transistor (T2) restant encore en saturation environ jusqu'au point central de la plage de transition,

-- lors de l'élévation de la tension d'entrée à la troisième borne d'entrée ($In_3$ -), le troisième transistor (T3) restant encore en saturation environ jusqu'au point central de la plage de transition, et

-- le point de fonctionnement dynamique du quatrième transistor (T4) variant par abaissement de la tension d'entrée à la quatrième borne d'entrée ($In_4$ +), du fonctionnement dans la plage linéaire jusqu'au fonctionnement en saturation.

7. Procédé selon la revendication 6, **caractérisé en ce que**,

   - en cas de régime maximal positif, la tension d'excitation respective est de

     -- environ 1,2 volts pour la première borne d'entrée ($In_1$ +),
     -- environ 0 volts pour la deuxième borne d'entrée ($In_2$ -),
     -- environ 0 volts pour la troisième borne d'entrée ($In_3$ -), et
     -- environ 1,2 volts pour la quatrième borne d'entrée ($In_4$ +) et

   - **en ce que**, en cas de régime maximal négatif, la tension d'excitation respective est de

     -- environ 0 volts pour la première borne d'entrée ($In_1$ +),
     -- environ 1,2 volts pour la deuxième borne d'entrée ($In_2$ -),
     -- environ 1,2 volts pour la troisième borne d'entrée ($In_3$ -) et
     -- environ de 0 volts pour la quatrième borne d'entrée ($In_4$ +).

8. Procédé selon les revendications 6 ou 7, **caractérisé en ce que**

   - la première résistance de dégradation de drain (R1) est environ aussi grande que la différence entre la résistance de drain-source (R2) du premier transistor (T1) dans la plage linéaire et la résistance de drain-source ($R2_S$) du premier transistor (T1) dans la plage de saturation et s'élève en tenant compte de la branche parallèle formée par une deuxième résistance de séparation (R4), la résistance de drain-source ($R5_S$)

du deuxième transistor (T2) dans la plage de saturation et la première résistance de dégradation de source (R6), et

   - **en ce que** la deuxième résistance de dégradation de drain (R9) est environ aussi grande que la différence entre la résistance de drain-source (R10) du troisième transistor (T3) dans la plage linéaire et la résistance de drain-source ($R10_S$) du troisième transistor (T3) dans la plage de saturation et s'élève en tenant compte de la branche parallèle formée par une quatrième résistance de séparation (R12), une résistance de drain-source ($R13_S$) du quatrième transistor (T4) dans la plage de saturation et une deuxième résistance de dégradation de source (R14).

9. Procédé selon l'une au moins des revendications 6 à 8, **caractérisé en ce que**

   - la première résistance de dégradation (R1) devient quasiment sans effet pour la première impédance de sortie ($Z_{Out1}$) lorsque le point de fonctionnement dynamique du premier transistor (T1) varie par abaissement de la tension d'entrée à la première borne d'entrée ($In_1$ +), du fonctionnement dans la plage linéaire jusqu'au fonctionnement dans la plage de saturation, et
   - **en ce que** la deuxième résistance de dégradation de drain (R9) s'apprête à passer d'un état sans effet pour la deuxième impédance de sortie ($Z_{Out2}$) à un état contribuant faiblement à la deuxième impédance de sortie ($Z_{Out2}$) lorsque le point de fonctionnement dynamique du troisième transistor (T3) varie par élévation de la tension d'entrée à la troisième borne d'entrée ($In_3$ -), du fonctionnement de verrouillage jusqu'au fonctionnement dans la plage de saturation.

10. Procédé selon l'une au moins des revendications 6 à 9, **caractérisé en ce que**,

    - en augmentant la première résistance de séparation (R3) et la deuxième résistance de séparation (R4), on réduit des courants transversaux circulant dans la zone de transition dans le premier chemin (P1), et
    - **en ce que** l'on réduit des courants transversaux circulant dans la zone de transition dans le deuxième chemin (P2) en augmentant la troisième résistance de séparation (R11) et la quatrième résistance de séparation (R12).

11. Procédé selon l'une au moins des revendications 6 à 10, **caractérisé en ce que**,

    - en diminuant la première résistance série de sortie (R7) dans la plage de transition, la première impédance de sortie ($Z_{Out1}$) est réduite, et
- **en ce qu'**en diminuant la deuxième résistance série de sortie (R8) dans la plage de transition, la deuxième impédance de sortie ($Z_{Out2}$) est réduite.

12. Procédé selon l'une au moins des revendications 6 à 11, **caractérisé en ce que**,

   - la première borne d'entrée ($In_1$ +) et la quatrième borne d'entrée ($In_4$ +) sont commandées par décalage de phase, et
   - **en ce que** la deuxième borne d'entrée ($In_2$ -) et la troisième borne d'entrée ($In_3$ -) sont commandées par décalage de phase.

**Fig. 1A**

**Fig. 1B**

**Fig. 1C**

**Fig. 1D**

**Fig. 2A**

**Fig. 2B**

**Fig. 2C**

**Fig. 2D**

**EP 2 177 000 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 20030094977 A1
- US 6812733 B1